# EUROPÄISCHE PATENTSCHRIFT

(11) **EP 2 823 693 B1**
(45) Veröffentlichungstag und Bekanntmachung des Hinweises auf die Patenterteilung: **08.05.2019**
(21) Anmeldenummer: 12726780.5
(22) Anmeldetag: 31.05.2012
(51) Int. Cl.: H05H 7/00

(54) **ABLENKVORRICHTUNG ZUM ABLENKEN GELADENER TEILCHEN**
DEFLECTION DEVICE FOR DEFLECTING CHARGED PARTICLES
DISPOSITIF DE DÉFLEXION POUR LA DÉFLEXION DE PARTICULES CHARGÉES

(43) Veröffentlichungstag der Anmeldung: 14.01.2015
(73) Patentinhaber: Siemens Aktiengesellschaft, 80333 München (DE)
(72) Erfinder: APTAKER, Peter, Simon, Wantage Oxfordshire OX12 9LY (GB); BEASLEY, Paul, Abingdon Oxfordshire OX14 3XP (GB); HEID, Oliver, 91052 Erlangen (DE)
(86) Internationale Anmeldenummer: PCT/EP2012/060279
(87) Internationale Veröffentlichungsnummer: WO 2013/178276

(56) Entgegenhaltungen:
- E.S.MASUNOV ET AL: "Space Charge Effects and RF Focusing of Ribbon Beam in Ion Linac", PROBLEMS OF ATOMIC SCIENCE AND TECHNOLOGY. 2001-NO. 5.SERIES: NUCLEAR PHYSICS RESEARCH (39), 2001, Seiten 71-73, XP002697321,
- J.EGBERTS ET AL: "Design and Test of the LIPAc IPM", PROCEEDINGS OF BIW2012, NEWPORT NEWS, VIRGINIA, USA, November 2012 (2012-11), XP002697322, ISBN: 978-3-95450-121-2
- O.A.ANDERSON ET AL: "A Transverse-field-focussing (TFF) Accelerator for intense Ribbon Beams", IEEE TRANSACTIONS ON NUCLEAR SCIENCE, Bd. 30, Nr. 4, August 1983 (1983-08), Seiten 3215-3217, XP002697323,
- M.POGGI ET AL: "two-dimensional ionization Beam Profile Measurement", PROCEEDINGD OF DIPAC09 BASEL SWITZERLAND, September 2009 (2009-09), Seiten 384-386, XP002697324,

## Beschreibung

Die vorliegende Erfindung betrifft eine Ablenkvorrichtung zum Ablenken geladener Teilchen gemäß Patentanspruch 1.

Es ist bekannt, bewegte geladene Teilchen durch elektrische und/oder magnetische Felder abzulenken. Es ist ebenfalls bekannt, elektrische Felder durch Anlegen elektrischer Spannungen an leitfähige Platten zu generieren.

E.S.Masunov et al "Space Charge Effects and RF Focusing of Ribbon Beam in Ion Linac" problems of atomic sience and technology, 2001, n.5 series:nuclear physics research (39), 71-73 offenbart gekrümmte Elektroden in einem Linearbeschleuniger;

O.A.Anderson et al "A Transverse-Field-Focussing (TFF)Accelerator for Intense Ribbon Beams", IEEE Transaction on Nuclear Science, Vol. NS-30, No.4, August 1983 und M.Poggi et al "Two-Dimensional Ionisation Beam Profile Measurement" Proceedings of PAC'09, Basel, Switzerland offenbaren ein Paar paralleler gekrümmter Ablenkplatten, die zum Biegen und Fokussieren eines Teilchenstrahls in einem Kanal optimiert sind.

Eine Aufgabe der vorliegenden Erfindung besteht darin, eine verbesserte Ablenkvorrichtung zum Ablenken geladener Teilchen bereitzustellen. Diese Aufgabe wird durch eine Ablenkvorrichtung mit den Merkmalen des Anspruchs 1 gelöst. Bevorzugte Weiterbildungen sind in den abhängigen Ansprüchen angegeben.

Eine Ablenkplatte zum Ablenken geladener Teilchen nach Anspruch 1 weist eine nicht-planare Form auf. Vorteilhafterweise generiert diese Ablenkplatte im Vergleich zu einer planaren Ablenkplatte ein elektrisches Feld mit einem verbesserten räumlichen Verlauf.

In einer bevorzugten Ausführungsform nach Anspruch 1 der Ablenkplatte ist diese um eine in eine erste Raumrichtung orientierte Achse gekrümmt. Vorteilhafterweise weist eine zur ersten Raumrichtung senkrechte Komponente eines durch die Ablenkplatte generierten elektrischen Felds dann in eine weitere zur ersten Raumrichtung senkrechte Raumrichtung einen flacheren Verlauf auf, als dies bei einer planaren Ablenkplatte der Fall ist. Vorteilhafterweise vereinfacht dies das Ablenken einzelner Pakete geladener Teilchen aus einem Strahl mit einer Vielzahl aufeinanderfolgender Teilchenpakete.

In einer besonders bevorzugten Ausführungsform der Ablenkplatte weist diese eine Zylindermantelbogenform auf. Vorteilhafterweise haben Untersuchungen ergeben, dass eine Zylindermantelbogenform einen besonders vorteilhaften Verlauf des elektrischen Felds generiert. Ein weiterer Vorteil besteht darin, dass eine Ablenkplatte mit einer Zylindermantelbogenform vergleichsweise einfach hergestellt werden kann.

In einer zweckmäßigen Ausführungsform der Ablenkplatte weist diese ein leitfähiges Material, insbesondere ein Metall, auf. Vorteilhafterweise kann die Ablenkplatte dann auf ein elektrisches Potential geladen werden.

Eine erfindungsgemäße Ablenkvorrichtung zum Ablenken geladener Teilchen weist eine erste Ablenkplatte der vorgenannten Art auf. Vorteilhafterweise kann diese Ablenkvorrichtung zum Ablenken geladener Teilchen eines Teilchenstrahls genutzt werden. Wegen der vorteilhaft ausgebildeten Ablenkplatte kann die Ablenkvorrichtung dann zum selektiven Ablenken einzelner Teilchenpakete aus einem Strahl aufeinanderfolgender Pakete geladener Teilchen verwendet werden.

In einer bevorzugten Ausführungsform nach Anspruch 1 der Ablenkvorrichtung weist diese eine zweite Ablenkplatte der vorgenannten Art auf. Vorteilhafterweise kann zwischen den Ablenkplatten der Ablenkvorrichtung dann eine Potentialdifferenz generiert werden.

In einer besonders bevorzugten Ausführungsform nach Anspruch 1 der Ablenkvorrichtung ist die zweite Ablenkplatte spiegelbildlich zur ersten Ablenkplatte angeordnet. Vorteilhafterweise ergibt sich zwischen den beiden Ablenkplatten der Ablenkvorrichtung dann ein besonders günstiger räumlicher Verlauf eines elektrischen Felds.

In einer besonders bevorzugten Ausführungsform nach Anspruch 1 der Ablenkvorrichtung sind beide Ablenkplatten um jeweils eine in eine erste Raumrichtung orientierte Achse gekrümmt. Dabei sind die erste Ablenkplatte und die zweite Ablenkplatte in eine zur ersten Raumrichtung senkrechte zweite Raumrichtung voneinander beabstandet. Außerdem sind die erste Ablenkplatte und die zweite Ablenkplatte bezüglich einer zur zweiten Raumrichtung senkrechten Ebene spiegelbildlich angeordnet. Vorteilhafterweise verläuft bei dieser Ablenkvorrichtung eine in die zweite Raumrichtung weisende Komponente eines elektrischen Felds in eine zur ersten Raumrichtung und zur zweiten Raumrichtung senkrechte Raumrichtung flach.

Besonders bevorzugt sind die konkaven Oberflächen der Ablenkplatten einander zugewandt. Vorteilhafterweise ist der Feldverlauf der in die zweite Raumrichtung weisenden Komponente des elektrischen Felds in eine zur ersten Raumrichtung und zur zweiten Raumrichtung senkrechte dritte Raumrichtung dann flach, ohne dass die Ablenkplatten der Ablenkvorrichtung eine große Länge in die dritte Raumrichtung aufweisen müssen.

In einer zusätzlichen Weiterbildung der Ablenkvorrichtung weist diese eine dritte Ablenkplatte und eine vierte Ablenkplatte auf. Dabei ist die dritte Ablenkplatte gegenüber der ersten Ablenkplatte in eine zur ersten Raumrichtung und zur zweiten Raumrichtung senkrechte dritte Raumrichtung verschoben. Die vierte Ablenkplatte ist außerdem gegenüber der zweiten Ablenkplatte in die dritte Raumrichtung verschoben. Vorteilhafterweise kann dann zwischen der dritten Ablenkplatte und der vierten Ablenkplatte eine andere Potentialdifferenz angelegt werden, als zwischen der ersten Ablenkplatte und der zweiten Ablenkplatte.

Bevorzugt ist die Ablenkvorrichtung ausgebildet, ein sich in die dritte Raumrichtung bewegendes geladenes Teilchen in die zweite Raumrichtung abzulenken. Vorteilhafterweise kann die Ablenkvorrichtung dann verwendet werden, um einzelne Teilchen oder Pakete von Teilchen aus einem Teilchenstrahl selektiv abzulenken.

Die oben beschriebenen Eigenschaften, Merkmale und Vorteile dieser Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Hierbei zeigen:
- Figur 1: eine schematische Darstellung eines Partikeltherapiegeräts;
- Figur 2: eine schematische Darstellung einer Ablenkvorrichtung;
- Figur 3: einen ersten Schnitt durch ein Plattenpaar der Ablenkvorrichtung;
- Figur 4: eine Aufsicht auf das Plattenpaar der Ablenkvorrichtung;
- Figur 5: einen zweiten Schnitt durch das Plattenpaar der Ablenkvorrichtung;
- Figur 6: einen ersten Graphen eines Feldstärkenverlaufs innerhalb des Plattenpaars; und
- Figur 7: einen zweiten Graphen des Feldstärkenverlaufs innerhalb des Plattenpaars.

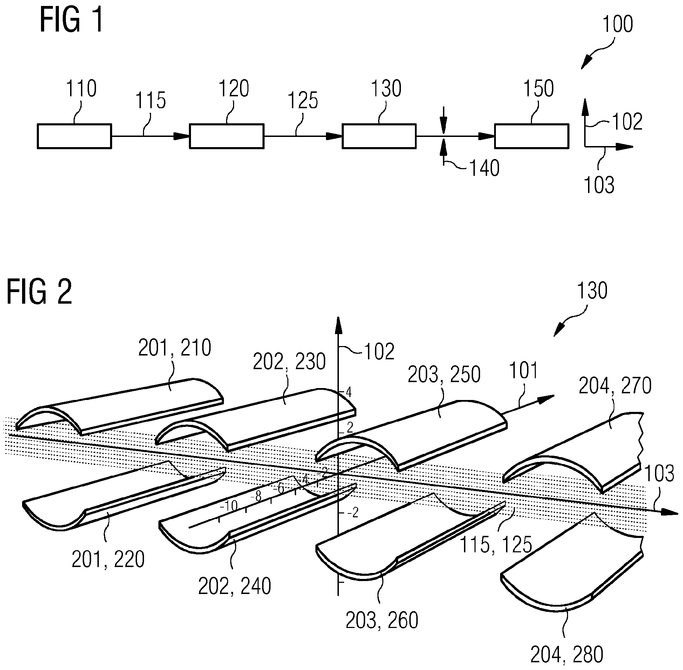

Figur 1 zeigt in stark schematisierter Darstellung ein Partikeltherapiegerät 100 als exemplarische Anwendung einer Ablenkvorrichtung. Ablenkvorrichtungen können jedoch auch in einer Vielzahl anderer Anwendungsbereiche Verwendung finden.

Die vorliegende Erfindung ist keinesfalls auf das Gebiet der Partikeltherapiegeräte beschränkt.

Das Partikeltherapiegerät 100 kann zum Durchführen einer Partikeltherapie verwendet werden, bei der ein erkrankter Körperteil eines Patienten mit geladenen Teilchen (Partikeln) beschossen wird. Bei den geladenen Teilchen kann es sich beispielsweise um Protonen handeln. Bei der Erkrankung des Patienten kann es sich beispielsweise um einen Tumor handeln.

Das Partikeltherapiegerät 100 umfasst eine Ionenquelle 110, eine Paketiervorrichtung 120, eine Ablenkvorrichtung 130, eine Blende 140 und einen Teilchenbeschleuniger 150, die in eine z-Richtung 103 hintereinander angeordnet sind. Die Ionenquelle 110 dient zum Erzeugen eines Strahls 115 geladener Teilchen. Bei den Teilchen des Teilchenstrahls 115 kann es sich beispielsweise um Protonen handeln. Die Teilchen des Teilchenstrahls 115 verlassen die Ionenquelle 110 in z-Richtung 103. Die Teilchen des Teilchenstrahls 115 können beim Verlassen der Ionenquelle 110 beispielsweise eine Energie von 10 keV bis 20 keV aufweisen.

Die Paketiervorrichtung 120 dient dazu, den kontinuierlichen Teilchenstrahl 115 in diskrete Teilchenpakete 125 zu unterteilen. Die Teilchenpakete 125 verlassen die Paketiervorrichtung 120 in z-Richtung 103. Die Paketiervorrichtung 120 kann auch entfallen.

Die Ablenkvorrichtung 130 dient dazu, einzelne Teilchenpakete 125 (oder einzelne Teilchen des kontinuierlichen Teilchenstrahls 115) selektiv gegenüber ihrer in z-Richtung 103 verlaufenden Bewegung in eine zur z-Richtung 103 senkrechte y-Richtung 102 abzulenken.

Durch die Ablenkvorrichtung 130 abgelenkte Teilchen und Teilchenpakete 125 passieren die der Ablenkvorrichtung 130 nachfolgende Blende 140 nicht oder nicht vollständig, während nicht-abgelenkte Teilchen und Teilchenpakete 125 die Blende 140 passieren. In alternativen Ausführungsformen des Partikeltherapiegerätes 100 passieren nur durch die Ablenkvorrichtung 130 in y-Richtung 102 abgelenkte Teilchen und Teilchenpakete 125 die Blende 140 vollständig.

Teilchen und Teilchenpakete 125, die die Blende 140 passiert haben, gelangen in den Teilchenbeschleuniger 150, wo sie auf eine höhere kinetische Energie von beispielsweise 80 MeV bis 250 MeV beschleunigt werden. Der Teilchenbeschleuniger 150 kann beispielsweise ein Linearbeschleuniger sein. Insbesondere kann es sich bei dem Teilchenbeschleuniger 150 um einen RF-Linearbeschleuniger handeln.

Figur 2 zeigt eine schematisierte Darstellung der Ablenkvorrichtung 130. Die Ablenkvorrichtung 130 umfasst in der in Figur 2 gezeigten Ausführungsform acht Ablenkplatten zum Ablenken der Teilchenpakete 125 geladener Teilchen. Im Einzelnen umfasst die Ablenkvorrichtung 130 in der gezeigten Ausführungsform eine erste Ablenkplatte 210, eine zweite Ablenkplatte 220, eine dritte Ablenkplatte 230, eine vierte Ablenkplatte 240, eine fünfte Ablenkplatte 250, eine sechste Ablenkplatte 260, eine siebte Ablenkplatte 270 und eine achte Ablenkplatte 280.

Die erste Ablenkplatte 210 und die zweite Ablenkplatte 220 bilden ein erstes Plattenpaar 201. Die dritte Ablenkplatte 230 und die vierte Ablenkplatte 240 bilden ein zweites Plattenpaar 202. Die fünfte Ablenkplatte 250 und die sechste Ablenkplatte 260 bilden ein drittes Plattenpaar 203. Die siebte Ablenkplatte 270 und die achte Ablenkplatte 280 bilden ein viertes Plattenpaar 204. In anderen Ausführungsformen kann die Ablenkvorrichtung 130 auch weniger als vier Plattenpaare 201, 202, 203, 204 oder mehr als vier Plattenpaare 201, 202, 203, 204 aufweisen.

Die Plattenpaare 201, 202, 203, 204 sind in z-Richtung 103 hintereinander angeordnet. Die beiden jeweiligen Ablenkplatten jedes Plattenpaars 201, 202, 203, 204 befinden sich in z-Richtung 103 und in einer zur y-Richtung 102 und zur z-Richtung 103 senkrechten x-Richtung 101 an jeweils gemeinsamer Position und sind in y-Richtung 102 voneinander beabstandet. Die Teilchenpakete 125 verlaufen in z-Richtung 103 zwischen den beiden jeweiligen Ablenkplatten der Plattenpaare 201, 202, 203, 204.

Die Ablenkplatten 210, 220, 230, 240, 250, 260, 270, 280 bestehen aus einem elektrisch leitenden Material, bevorzugt aus einem Metall, oder weisen zumindest ein elektrisch leitendes Material auf, beispielsweise in Form einer Beschichtung.

Zwischen den Ablenkplatte der Plattenpaare 201, 202, 203, 204 kann jeweils eine Potentialdifferenz und damit ein elektrisches Feld generiert werden, um die sich in z-Richtung 103 bewegenden Teilchen der Teilchenpakete 125 in y-Richtung 102 abzulenken. Beispielsweise können die erste Ablenkplatte 210 des ersten Plattenpaars 201 auf eine positive Spannung und die zweite Ablenkplatte 220 des ersten Plattenpaars 201 auf eine negative Spannung desselben Betrags gelegt werden. Die in den verschiedenen Plattenpaaren 201, 202, 203, 204 erzeugten Potentialdifferenzen können sich voneinander unterscheiden. Um nur einzelne Teilchenpakete 125 der in rascher zeitlicher Folge aufeinanderfolgenden Teilchenpakete 125 in y-Richtung 102 abzulenken, müssen zeitlich kurze Spannungspulse an die Ablenkplatten 210, 220, 230, 240, 250, 260, 270, 280 angelegt werden.

Eine in y-Richtung 102 weisende Komponente eines in einem Plattenpaar 201, 202, 203, 204 generierten elektrischen Felds weist in z-Richtung 103 einen gaussförmigen Verlauf auf, falls die Ablenkplatte 210, 220, 230, 240, 250, 260, 270, 280 als planare Platten ausgebildet sind. Günstiger ist allerdings, wenn der Verlauf der in y-Richtung 102 weisenden Komponente des elektrischen Felds in z-Richtung 103 innerhalb eines Plattenpaars 201, 202, 203, 204 einer angenäherten Rechteckfunktion folgt.

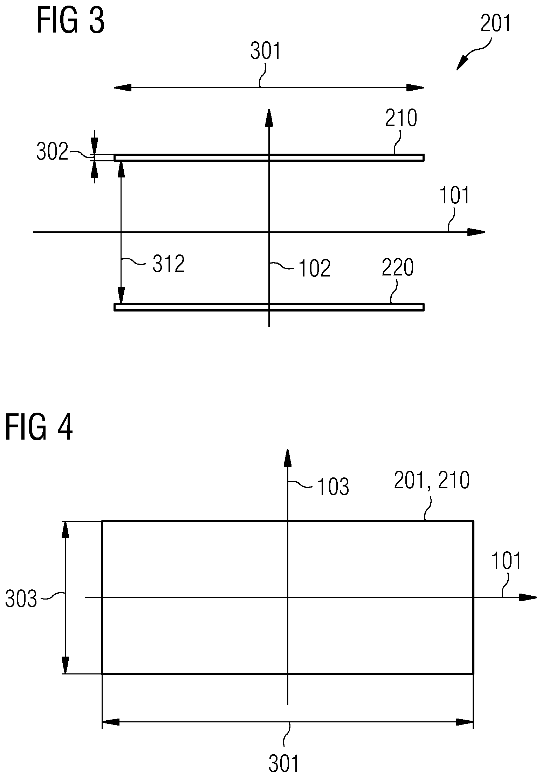

Um diesen bevorzugten räumlichen Verlauf der in y-Richtung 102 weisenden Komponente des elektrischen Felds anzunähern, weisen die Ablenkplatten 210, 220, 230, 240, 250, 260, 270, 280 der Ablenkvorrichtung 130 jeweils eine nicht-planare Geometrie auf. Dies wird nachfolgend anhand der Figuren 3 bis 5 erläutert, die Darstellungen des ersten Plattenpaars 201 zeigen. Die übrigen Plattenpaare 202, 203, 204 sind bevorzugt identisch zum ersten Plattenpaar 201 ausgebildet.

Figur 3 zeigt einen ersten Schnitt durch das erste Plattenpaar 201. Der Schnitt verläuft dabei senkrecht zur z-Richtung 103. Die erste Ablenkplatte 210 und die zweite Ablenkplatte 220 des ersten Plattenpaars 201 weisen in x-Richtung 101 eine Breite 301 auf. Die Breite 301 kann beispielsweise 4 mm betragen. Die Ablenkplatten 210, 220 weisen in y-Richtung 102 jeweils eine Dicke 302 auf. Die Dicke 302 kann beispielsweise 0,1 mm betragen. Die erste Ablenkplatte 210 und die zweite Ablenkplatte 220 weisen in y-Richtung 102 einen Abstand 312 voneinander auf. Der Abstand 312 kann beispielsweise 6 mm betragen.

Figur 4 zeigt eine Aufsicht auf die erste Ablenkplatte 210 des ersten Plattenpaars 201 in einer der y-Richtung 102 entgegengesetzten Blickrichtung. Die erste Ablenkplatte 210 weist in z-Richtung 103 eine Länge 303 auf, die beispielsweise 4 mm betragen kann. Die zweite Ablenkplatte 220 des ersten Plattenpaars 201 weist in z-Richtung 103 bevorzugt die gleiche Länge 303 wie die erste Ablenkplatte 210 auf.

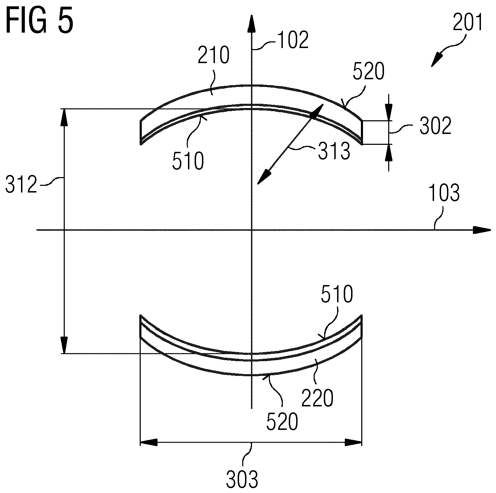

Figur 5 zeigt einen zweiten Schnitt durch die Ablenkplatten 210, 220 des ersten Plattenpaars 201. Der Schnitt erfolgt in Figur 5 senkrecht zur x-Richtung 101. Jede der Ablenkplatten 210, 220 ist um eine zur x-Richtung 101 parallele Achse gekrümmt. Bevorzugt folgt die Krümmung dabei einem Kreisbogen, so dass die Ablenkplatten 210, 220 zylindermantelbogenförmig ausgebildet sind. Dabei weisen die Ablenkplatte 210, 220 jeweils einen Krümmungsradius 313 auf. Der Krümmungsradius 313 kann beispielsweise zwischen 1 mm und 4 mm liegen. Die gekrümmten Ablenkplatten 210, 220 weisen jeweils eine konkave Oberfläche 510 und eine konvexe Oberfläche 520 auf. Die konkaven Oberflächen 510 der Ablenkplatte 210, 220 sind einander zugewandt.

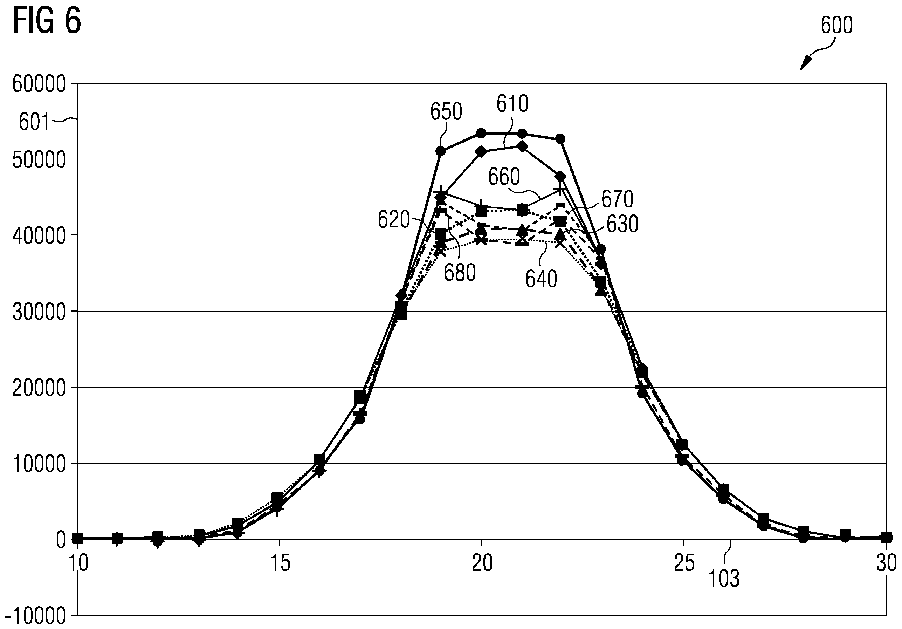

Figur 6 zeigt in einem ersten Graphen 600 räumliche Feldstärkenverläufe, die sich bei unterschiedlichen Krümmungsradien 313 der Ablenkplatten 210, 220, 230, 240, 250, 260, 270, 280 ergeben. Auf einer horizontalen Achse des ersten Graphen 600 ist die z-Richtung 103 im Bereich eines Plattenpaars 201, 202, 203, 204 aufgetragen. Auf einer vertikalen Achse des ersten Graphen 600 ist eine in y-Richtung 102 weisende Komponente 601 einer elektrischen Feldstärke aufgetragen.

Ein erster Feldverlauf 610 gibt den Verlauf der elektrischen Feldstärke in y-Richtung 102 bei einem sehr großen Krümmungsradius 313 von beispielhaft gewählten 1000 mm an. Ein derart großer Krümmungsradius 313 stellt eine Nährung an planare Ablenkplatten 210, 220, 230, 240, 250, 260, 270, 280 dar. Der erste Feldverlauf 610 gibt somit nährungsweise einen Feldverlauf an, der sich bei Verwendung planarer Ablenkplatten 210, 220, 230, 240, 250, 260, 270, 280 ergibt. Ein zweiter Feldverlauf 620 gibt den Verlauf der in y-Richtung 102 weisenden Feldkomponente bei Verwendung eines Krümmungsradius 313 von 4 mm an. Ein dritter Feldverlauf 630 gibt den Verlauf der Feldstärke bei Verwendung eines Krümmungsradius 313 von 3 mm an. Ein vierter Feldverlauf 640 gibt den Verlauf der in y-Richtung 102 weisenden Komponente des elektrischen Felds bei Verwendung eines Krümmungsradius von 2,5 mm an. Die Feldverläufe 610, 620, 630, 640 sind dabei jeweils an einer in y-Richtung 102 im Zentrum zwischen den Ablenkplatten des Plattenpaars 201, 202, 203, 204 befindlichen Position angegeben. Erkennbar ist, dass der Verlauf der Feldstärke 601 in y-Richtung 102 umso rechteckiger ist, je geringer der Krümmungsradius 313 gewählt ist, je stärker also die Ablenkplatten 210, 220, 230, 240, 250, 260, 270, 280 gekrümmt sind.

Im ersten Graphen 600 der Figur 6 sind außerdem ein fünfter Feldverlauf 650, ein sechster Feldverlauf 660, ein siebter Feldverlauf 670 und ein achter Feldverlauf 680 dargestellt. Der fünfte Feldverlauf 650 ergibt sich bei Verwendung eines Krümmungsradius 313 von 1000 mm. Der sechste Feldverlauf 660 ergibt sich bei Verwendung eines Krümmungsradius 313 von 4 mm. Der siebte Feldverlauf 670 ergibt sich bei Verwendung eines Krümmungsradius 313 von 3 mm. Der achte Feldverlauf 680 ergibt sich bei Verwendung eines Krümmungsradius 313 von 2,5 mm. Die Feldverläufe 650, 660, 670, 680 ergeben sich jeweils an einer Position in y-Richtung 102, die nicht genau zwischen den beiden Platten des jeweiligen Plattenpaars 201, 202, 203, 204 liegt, sondern näher an einer der Platten des jeweiligen Plattenpaars 201, 202, 203, 204 angeordnet ist. Erkennbar ist, dass jeder der Feldverläufe 650, 660, 670, 680 im Bereich um das Zentrum des Plattenpaars 201, 202, 203, 204 in z-Richtung 103 konvex ausgebildet ist. Die Konvexität ist dabei umso größer, je geringer der Krümmungsradius 313 gewählt ist. Da eine solche Konvexität des Verlaufs der in y-Richtung 102 weisenden Komponente des elektrischen Felds in z-Richtung 103 mit Nachteilen verbunden sein kann, sollte der Krümmungsradius 313 nicht zu klein gewählt werden.

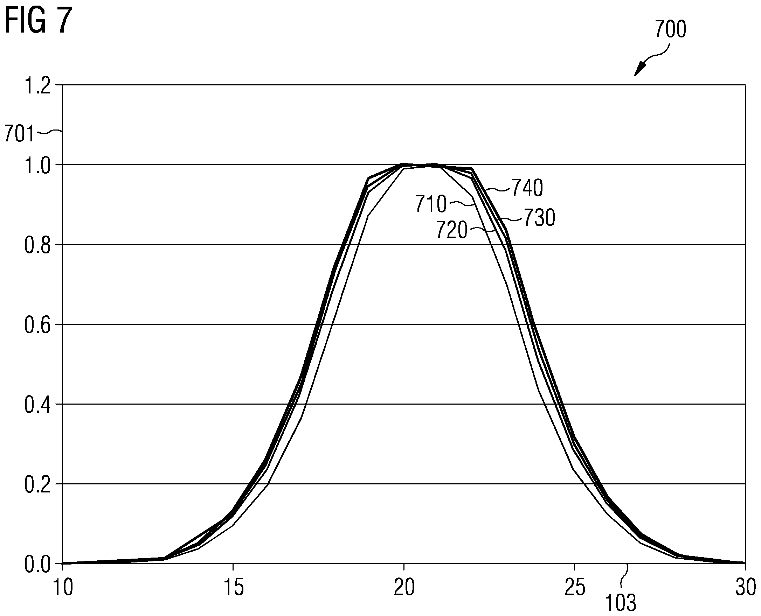

Figur 7 zeigt einen zweiten Graphen 700 des Verlaufs der in y-Richtung 102 weisenden Komponente des elektrischen Felds entlang der z-Richtung 103. Auf der horizontalen Achse des zweiten Graphen 700 ist wiederum die z-Richtung 103 im Bereich eines Plattenpaars 201, 202, 203, 204 aufgetragen. Auf einer vertikalen Achse des zweiten Graphen 700 ist eine normalisierte Feldstärke 701 einer in y-Richtung 102 weisenden Komponente des elektrischen Felds aufgetragen. Ein erster Feldverlauf 710, ein zweiter Feldverlauf 720, ein dritter Feldverlauf 730 und ein vierter Feldverlauf 740 geben den Verlauf der in y-Richtung 102 weisenden Komponente des elektrischen Felds entlang der z-Richtung 103 in der Mitte zwischen den beiden Ablenkplatten des jeweiligen Plattenpaars 201, 202, 203, 204 an. Dabei beträgt der Krümmungsradius 313 beim ersten Feldverlauf 710 1000 mm, beim zweiten Feldverlauf 720 4 mm, beim dritten Feldverlauf 730 3 mm und beim vierten Feldverlauf 740 2,5 mm. Aus der normalisierten Darstellung des zweiten Graphen 700 ist noch deutlicher erkennbar, dass der Verlauf der in y-Richtung 102 weisenden Komponente des elektrischen Felds in z-Richtung 103 umso rechteckförmiger verläuft, je geringer der Krümmungsradius 313 der Ablenkplatten 210, 220, 230, 240, 250, 260, 270, 280 gewählt wird.

Obwohl die Erfindung im Detail durch das bevorzugte Ausführungsbeispiel näher illustriert und beschrieben wurde, ist die Erfindung nicht durch die offenbarten Beispiele eingeschränkt. Andere Variationen können vom Fachmann hieraus abgeleitet werden, ohne den Schutzumfang der Erfindung zu verlassen.

Der Umfang der Erfindung ist durch die Ansprüche definiert.

## Patentansprüche

1. Ablenkvorrichtung (130) zum Ablenken geladener Teilchen, wobei die Ablenkvorrichtung (130) ausgebildet ist, ein sich in eine dritte Raumrichtung (103) bewegendes geladenes Teilchen in eine zweite Raumrichtung (102) abzulenken,
wobei die Ablenkvorrichtung (130) eine erste Ablenkplatte (210) und eine zweite Ablenkplatte (220) aufweist,
und wobei
- die erste Ablenkplatte (210) und die zweite Ablenkplatte (220) jeweils eine nicht-planare Form aufweisen,
- die erste Ablenkplatte (210) und die zweite Ablenkplatte (220) jeweils um eine in eine erste Raumrichtung (101) orientierte Achse gekrümmt sind,
- die zweite Ablenkplatte (220) spiegelbildlich zur ersten Ablenkplatte (210) angeordnet ist,
wobei die erste, die zweite und die dritte Raumrichtung senkrecht aufeinander stehen.

2. Ablenkvorrichtung (130) gemäß Anspruch 1,
wobei die erste Ablenkplatte (210) und die zweite Ablenkplatte (220) in eine zur ersten Raumrichtung (101) senkrechte zweite Raumrichtung (102) voneinander beabstandet sind,
wobei die erste Ablenkplatte (210) und die zweite Ablenkplatte (220) bezüglich einer zur zweiten Raumrichtung (102) senkrechten Ebene spiegelbildlich angeordnet sind.

3. Ablenkvorrichtung (130) gemäß Anspruch 2,
wobei konkave Oberflächen (510) der Ablenkplatten (210, 220) einander zugewandt sind.

4. Ablenkvorrichtung (130) gemäß einem der Ansprüche 2 oder 3,
wobei die Ablenkvorrichtung (130) eine dritte Ablenkplatte (230) und eine vierte Ablenkplatte (240) aufweist, wobei die dritte Ablenkplatte (230) gegenüber der ersten Ablenkplatte (210) in eine zur ersten Raumrichtung (101) und zur zweiten Raumrichtung (102) senkrechte dritte Raumrichtung (103) verschoben ist, wobei die vierte Ablenkplatte (240) gegenüber der zweiten Ablenkplatte (220) in die dritte Raumrichtung (103) verschoben ist.

5. Ablenkvorrichtung (130) gemäß einem der vorhergehenden Ansprüche,
wobei zumindest eine der Ablenkplatten (210, 220) eine Zylindermantelbogenform aufweist.

6. Ablenkvorrichtung (130) gemäß einem der vorhergehenden Ansprüche,
wobei zumindest eine der Ablenkplatten (210, 220) ein leitfähiges Material, insbesondere ein Metall, aufweist.

## Claims

1. Deflection device (130) for deflecting charged particles, wherein the deflection device (130) is embodied to deflect a charged particle moving in a third spatial direction (103) into a second spatial direction (102), wherein the deflection device (130) comprises a first deflection plate (210) and a second deflection plate (220),
and wherein
- the first deflection plate (210) and the second deflection plate (220) each have a non-planar shape,
- the first deflection plate (210) and the second deflection plate (220) are each curved about an axis oriented in a first spatial direction (101),
- the second deflection plate (220) is disposed in a mirror-imaged manner to the first deflection plate (210), wherein the first, the second and the third spatial direction are perpendicular to one another.

2. Deflection device (130) according to Claim 1,
wherein the first deflection plate (210) and the second deflection plate (220) are spaced apart in a second spatial direction (102) perpendicular to the first spatial direction (101),
wherein the first deflection plate (210) and the second deflection plate (220) are disposed in a mirror-imaged manner in relation to a plane perpendicular to the second spatial direction (102).

3. Deflection device (130) according to Claim 2,
wherein concave surfaces (510) of the deflection plates (210, 220) face one another.

4. Deflection device (130) according to either of Claims 2 and 3,
wherein the deflection device (130) comprises a third deflection plate (230) and a fourth deflection plate (240),
wherein the third deflection plate (230) is displaced in relation to the first deflection plate (210) in a third spatial direction (103) perpendicular to the first spatial direction (101) and to the second spatial direction (102),
wherein the fourth deflection plate (240) is displaced in relation to the second deflection plate (220) in the third spatial direction (103).

5. Deflection device (130) according to any one of the preceding claims,
wherein at least one of the deflection plates (210, 220) has an arced shape like a cylinder lateral surface.

6. Deflection device (130) according to any one of the preceding claims,
wherein at least one of the deflection plates (210, 220) comprises a conductive material, more particularly a metal.

## Revendications

1. Dispositif de déflexion (130) pour la déflexion de particules chargées ; dans lequel le dispositif de déflexion (130) est réalisé pour la déflexion dans une deuxième direction spatiale (102) d'une particule chargée mobile dans une troisième direction spatiale (103) ; dans lequel le dispositif de déflexion (130) présente une première plaque de déflexion (210) et une deuxième plaque de déflexion (220) ; et dans lequel
- la première plaque de déflexion (210) et la deuxième plaque de déflexion (220) présentent respectivement une forme non planaire ;
- la première plaque de déflexion (210) et la deuxième plaque de déflexion (220) sont respectivement incurvées autour d'un axe orienté dans une première direction spatiale (101) ;
- la deuxième plaque de déflexion (220) est disposée en symétrie par rapport à la première plaque de déflexion (210) ; dans lequel la première, la deuxième et la troisième direction spatiale sont perpendiculaires les unes par rapport aux autres.

2. Dispositif de déflexion (130) selon la revendication 1, dans lequel la première plaque de déflexion (210) et la deuxième plaque de déflexion (220) sont disposées à distance l'une de l'autre dans une deuxième direction spatiale (102) perpendiculaire à la première direction spatiale (101) ; dans lequel la première plaque de déflexion (210) et la deuxième plaque de déflexion (220) sont disposées en symétrie par rapport à un plan perpendiculaire à la deuxième direction spatiale (102).

3. Dispositif de déflexion (130) selon la revendication 2, dans lequel des surfaces concaves (510) des plaques de déflexion (210, 220) sont orientées l'une vers l'autre.

4. Dispositif de déflexion (130) selon l'une quelconque des revendications 2 ou 3, dans lequel le dispositif de déflexion (130) présente une troisième plaque de déflexion (230) et une quatrième plaque de déflexion (240) ; dans lequel la troisième plaque de déflexion (230) est décalée dans une troisième direction spatiale (103) perpendiculaire à la première direction spatiale (101) et à la deuxième direction spatiale (102) ; dans lequel la quatrième plaque de déflexion (240) est décalée dans la troisième direction spatiale (103) par rapport à la deuxième plaque de déflexion (220).

5. Dispositif de déflexion (130) selon l'une quelconque des revendications précédentes, dans lequel au moins une des plaques de déflexion (210, 220) présente une configuration arquée en forme d'enveloppe cylindrique.

6. Dispositif de déflexion (130) selon l'une quelconque des revendications précédentes, dans lequel au moins une des plaques de déflexion (210, 220) présente un matériau conducteur, en particulier un métal.
